# EUROPEAN PATENT APPLICATION

(11) **EP 1 493 838 A1**
(43) Date of publication of application: **05.01.2005**
(21) Application number: 03715703.9
(22) Date of filing: 01.04.2003
(51) Int. Cl.: C23C 14/56, G11B 7/26, H01L 21/68

(54) **REPLACEMENT UNIT AND REPLACEMENT METHOD FOR SUBSTRATE IN THIN-FILM FORMING DEVICE**

(30) Priority: 08.04.2002 JP 2002104895
(71) Applicant: TDK Corporation, Chuo-ku, Tokyo 103-8272 (JP)
(72) Inventor: KOSHIKAWA, Masato c/o TDK Corporation, Chuo-ku, Tokyo 103-8272 (JP); WATANABE, Hideaki c/o TDK Corporation, Chuo-ku, Tokyo 103-8272 (JP); ISHIZAKI, Hideki c/o TDK Corporation, Chuo-ku, Tokyo 103-8272 (JP); USAMI, Mamoru c/o TDK Corporation, Chuo-ku, Tokyo 103-8272 (JP)
(74) Representative: Grünecker, Kinkeldey, Stockmair & Schwanhäusser
(86) International application number: PCT/JP2003/004169
(87) International publication number: WO 2003/085159

(57) **Abstract**

The present invention receives a film-coated substrate together with a carrier from a substrate replacing head which receives the substrate and carrier from a film forming device, while the substrate is transferred between the substrate replacing head and a stage on which the substrate is to be set; transfers only the substrate to the stage while the carrier is held; cools the carrier while it is held; then receives an uncoated substrate set on the stage by the carrier being held; and transfers the substrate and carrier to the film forming device by the substrate replacing head. This structure prevents temperature rise at the substrate being coated with a film to allow control of carrier temperature for a thin film forming process which uses a carrier for holding the substrate.

## Description

### Technical Field

The present invention relates to a substrate replacing unit that performs supply and receipt of a substrate for a thin film forming device and method for replacing a substrate. More specifically, the present invention relates to a substrate replacing unit that receives a substrate on which a film has been already formed and the like from, and supplies a new substrate to, a thin film forming device, e.g., sputtering device, and method of receiving and supplying a substrate.

### Background Art

Various types of disks have been developed with a circular substrate which supports a recording medium, in particular that having a disk shape. These include CD-based disks, e.g., CD, CD-R and CD-RW; optical disks including DVD-based disks, e.g., DVD-ROM and DVD-R; and magneto-optical disks, e.g., MO and MD.

These disks are produced by providing thin films on a substrate, e.g., that of polycarbonate, by a varying method, e.g., sputtering or spin coating. The substrate is normally provided with a through-hole at the center for ease of substrate handling, e.g., for mounting a drive thereon.

Of thin films to be formed, a thin metallic film, e.g., that for a reflective film, is formed by sputtering, where a disk-like substrate is fixed and held to face a target in a vacuum chamber, kept at a given pressure by a gas for discharging, e.g., argon. In general, in this state, a voltage is applied to the target. This generates a discharge between the target and substrate to produce a plasma, and the ions in the plasma sputters the target constituting element on the target surface onto the substrate. The sputtered particles are deposited on the substrate to form a film thereon.

Some disks need a plurality of thin films to be formed by a sputtering device, depending on its film structure. A sputtering device for the above case is of the so-called multi-target type, which is provided with a plurality of film forming chambers arranged in a circle with a robot at the center for supplying substrates one by one to the chambers to be coated with a thin film therein. An optical disk or the like needs regions on which no film is formed, e.g., periphery around the hole at the center and periphery around the substrate. Therefore, the substrate is covered with jigs called an inner mask and outer mask on these regions during sputtering to form a thin film.

In a conventional sputtering device, therefore, an outer mask or the like is fixed on a substrate, and the substrate assembly is transferred to or from each film forming device or film forming chamber in a multi-target sputtering device. More specifically, in a multi-target sputtering device, an assembly of substrate and masks held and fixed on a holding jig called carrier is transferred to or from each film forming chamber.

An optical disk or the like may be coated with a non-metallic film, e.g., that of oxide or nitride, as a protective film, which is formed by sputtering with a target of oxide or nitride. An oxide or nitride target, however, generally needs a higher voltage for generating or maintaining a discharge, and a lower film forming speed to produce a film of good properties. Therefore, it takes a longer time to have a film of given thickness and exposes the substrate to a high-density plasma for a longer time, accordingly.

A substrate for an optical disk or the like is generally made of polycarbonate or the like, which is low in resistance to heat. Therefore, the substrate should be kept at its heat-resistance temperature or lower even during the film forming process by sputtering. When coated with an oxide film by plasma-aided sputtering, the substrate may be easily heated to its heat-resistance temperature or higher by radiation heat from the plasma, energy of the sputtered particles hitting the substrate or the like, because it is exposed to a high-density plasma for a longer film forming time.

One of the countermeasures against these problems is use of a carrier of higher heat capacity, to absorb part of thermal energy which would be otherwise directly transferred to the substrate in contact with the carrier, and thereby to retard time required for increasing substrate temperature. Another countermeasure is forming an oxide film or the like not in a single film forming chamber but in a plurality of chambers to take a longer time with inter-chamber cooling to control substrate temperature rise. In this case, however, the substrate may be eventually heated to its heat-resistance temperature or higher by heat from the carrier, when a quantity of heat accumulated in the carrier exceeds a certain level.

The temperature rise may be controlled by a treatment chamber dedicated for cooling between the film forming chambers. This concept, however, is inefficient for cooling a carrier itself, because of lack of heat-transferring media, e.g., air, around the carrier in a vacuum chamber with the result that heat accumulated in the carrier cannot be easily released. Moreover, increasing number of film forming or cooling chambers may increase film forming time to deteriorate treatment efficiency.

### DISCLOSURE OF THE INVENTION

It is an object of the present invention to provide a sputtering device which can control carrier temperature rise, in order to solve the above problems. It is another object of the present invention to provide a carrier supplying method which can control carrier temperature rise. It is still another object of the present invention to provide method of producing a disk-like recording medium using the above sputtering device.

The substrate replacing unit of the present invention, which can solve the above problems, transfers, between carrier holders in a film forming device, a substrate, mask of a magnetic material for covering a given part on the substrate and carrier comprising a magnetic material which holds the substrate and mask and is held by the carrier holder, wherein the unit comprises a substrate replacing hand equipped with a carrier attaching/detaching means for receiving the carrier on which the substrate and mask are mounted from the carrier holder and for holding the substrate, mask and carrier; head facing the substrate replacing hand for transferring the substrate, mask and carrier by a magnetic force between itself and the hand; mask fixing means for fixing the mask thereon; stage facing the head at a position different from that of the substrate replacing hand for transferring the mask and substrate between itself and head by the mask fixing means; and stand-by position located between the substrate replacing hand and stage, at which the carrier held by the head is cooled after it transfers the substrate and mask to the stage.

The carrier attaching/detaching means in the substrate replacing hand for the substrate replacing unit works in concert with carrier attaching/detaching holes provided in the carrier to pass therethrough, each being composed of an elongate through-hole of a given width and smaller diameter and circular through-hole of larger diameter. The substrate replacing hand is preferably composed of a substrate fixing member and carrier fixing pins, the substrate fixing member working to fix the substrate, mask and carrier, and being rotatable in the direction perpendicular to the substrate, and each of the carrier fixing pins being provided at a position corresponding to that of one of the carrier attaching/detaching holes in the substrate fixing member, and composed of a smaller-diameter section and larger-diameter section provided at the end of the smaller-diameter section, the former having a diameter to allow the smaller-diameter hole of the carrier fixing hole to be fit and longer than the depth of the smaller-diameter hole of the carrier fixing hole while the latter having a diameter to allow the larger-diameter hole of the fixing hole to be fit but not to allow the smaller-diameter hole to be fit.

The present invention also provides another substrate replacing unit which can solve the above problems. It replaces, between carrier holders in a film forming device, a film-coated and uncoated substrate with each other together with a mask for covering a given part on the substrate and carrier which holds the substrate and mask and is held by the carrier holder, wherein the unit comprises a substrate replacing hand which replaces, between the carrier holders, the film-coated and uncoated substrate with each other together with the mask and carrier; stage on which the film-coated or uncoated substrate and mask are set; and arm head which receives the film-coated substrate, mask and carrier from the substrate replacing hand, transfers the film-coated substrate and mask to the stage, stands by for a given time while holding the carrier, and then receives the uncoated substrate and mask from the stage.

The method of the present invention for replacing a substrate, which can solve the above problems, replaces, between carrier holders in a film forming device, a substrate, mask of a magnetic material for covering a given part on the substrate and carrier comprising a magnetic material which holds the substrate and mask and is held by the carrier holder, comprising a step of receiving the substrate, mask and carrier from the carrier holder by a substrate replacing hand; step of receiving the substrate, mask and carrier from the substrate replacing hand by an arm head; step of setting the substrate and mask received by the arm head on a stage; step of replacing the substrate and mask by a new substrate and mask on the stage; step of transferring the new substrate and mask together with the carrier which holds them to the substrate replacing hand by the arm head; and step of transferring the new substrate and mask together with the carrier which holds them to the carrier holder by the substrate replacing hand, wherein the carrier held by the arm head is cooled while the substrate and mask are replaced on the stage.

### BRIEF DESCRIPTION OF THE DRAWINGS

FIG. 1 is a top view outlining structure of the substrate replacing unit of the present invention and sputtering device;
FIG. 2 is a front view outlining structure of the carrier;
FIG. 3 is a cross-sectional view illustrating the substrate, mask and carrier transferred between the substrate replacing hand and first or second arm head;
FIG. 4 is a cross-sectional view illustrating the substrate, mask and carrier transferred between the carrier holder and substrate replacing hand;
FIG. 5 is a cross-sectional view illustrating the substrate and mask held by the first or second stage; and
FIG. 6 is a cross-sectional view illustrating the carrier held by the first or second arm head.

### BEST MODE FOR CARRYING OUT THE INVENTION

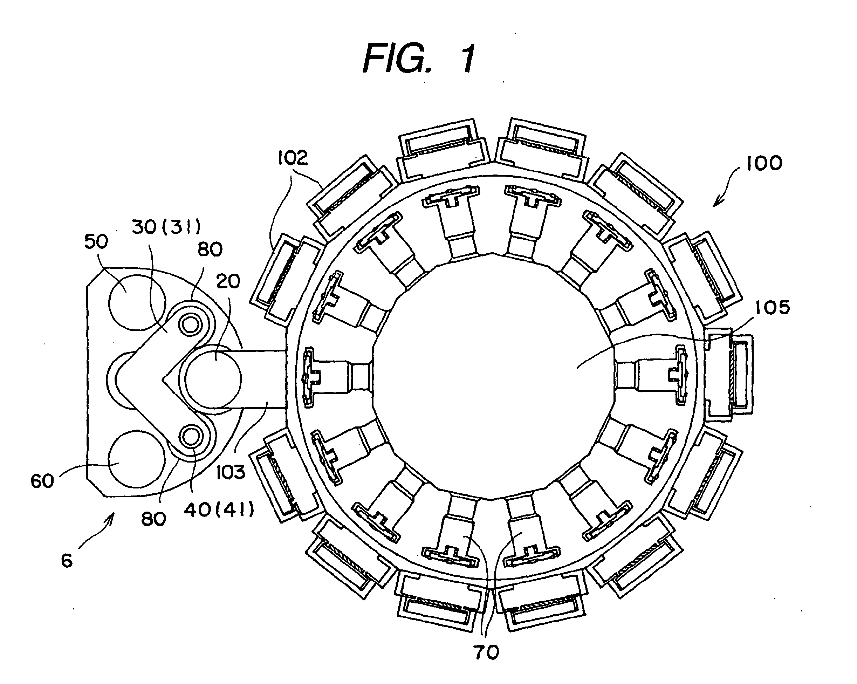

FIG. 1 presents a top view outlining structure of the substrate replacing unit of one embodiment of the present invention and sputtering device. This embodiment is described by taking, as an example, the sputtering device 100 having 14 chambers, 13 film forming chambers 102 and one substrate charging/discharging chamber 103. Each film forming chamber 102 located on each side of the tetradecagon is composed of various structures, e.g., those for limiting a discharge space to a specific region, e.g., in the vicinity of target (the so-called earth shield structure), for preventing the excess sputtered particles from being deposited in the unit inside (the so-called deposition shield structure), for introducing argon gas or the like for discharging, and for vacuum exhaust. However, these structures are not directly related to this invention, and their diagrammatic representation and description are omitted.

The carrier holding/transferring unit 105 is provided at the center of the circumference on which the film forming chambers 102 are located. It is equipped with the 14 carrier holders 70 radiating from the rotational center of the carrier holding/transferring unit 105, each simultaneously holding the substrate 1, mask 2 and carrier 10. The carrier 10 can be handled independently from the carrier holder 70 in the present invention. Each carrier holder 70 is facing each film forming chamber 102, while being rotated by the carrier holding/transferring unit 105.

The device shown in FIG. 1 rotates the carrier holders 70 clockwise to form thin films one by one on the substrates, where each of these holders 70 receives the substrate 1, mask 2 and carrier 10 at the substrate charging/discharging chamber. 103 while stopping in front of the film forming chamber 102 for a given time. When the substrate 1 has moved past the 13 film forming chambers 102 to complete the film forming step in the device 100, it is withdrawn together with the mask 2 and carrier 10 from the substrate charging/discharging chamber 103. The substrate replacing unit 6, positioned in front of the substrate charging/discharging chamber 103 receives the film-coated substrate 1 from the carrier holder 70 together with the mask 2 and carrier 10 by the substrate replacing hand 20.

The substrate replacing unit 6 is composed of the substrate replacing hand 20, first and second arm heads 30 and 40, and first and second stages 50 and 60. The first and second arm heads 30 and 40 have the first and second heads 31 and 41, respectively, at the front ends, and are connected to each other at a contained angle of around 90° at the other ends. They are supported by an arm head driving mechanism (not shown) in such a way that they can rotate around the connection. The first and second stages 50 and 60 are arranged to be 180° symmetrical to each other around the connection, and apart from the connection at the same distance as that between the connection and head 31 (or 41) center.

The substrate replacing hand 20, described later, is positioned at the midpoint between the first and second stages 50 and 60 on the same plane, and apart from the rotational center at the same distance as that between the connection center and head 31 (or 41) center. When the arm heads 30 and 40 are at the respective stand-by position 80, the first and second heads 31 and 41 are positioned at the midpoint between the first stage 50 and substrate replacing hand 20 and between the second stage 60 and substrate replacing hand 20, respectively, on the same plane. This design allows the second head 41 to be on the substrate replacing hand 20 on the same plane when the first head 31 is on the first stage 50, and similarly the first head 31 to be on the substrate replacing hand 20 on the same plane when the second head 41 is on the second stage 60.

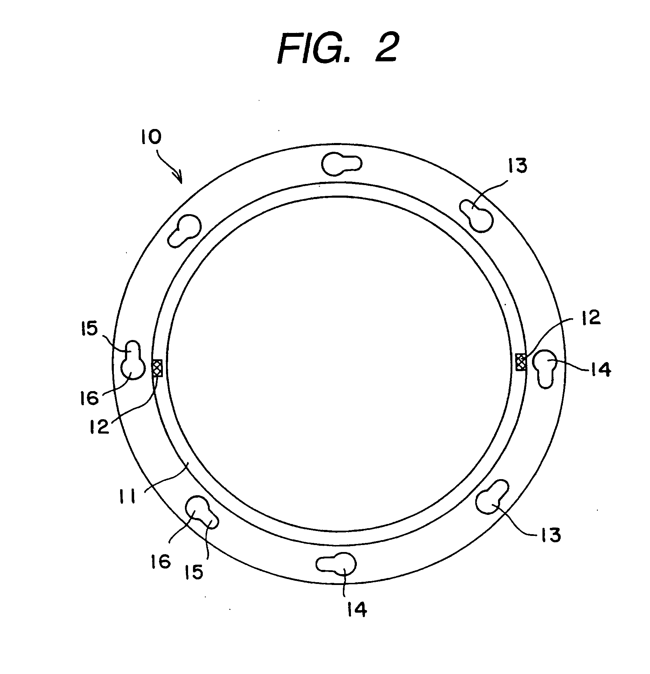

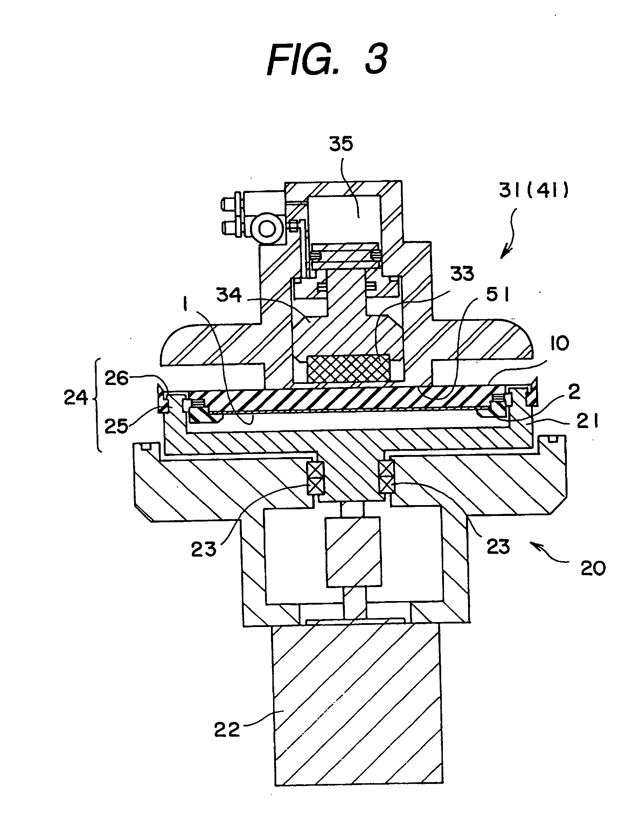

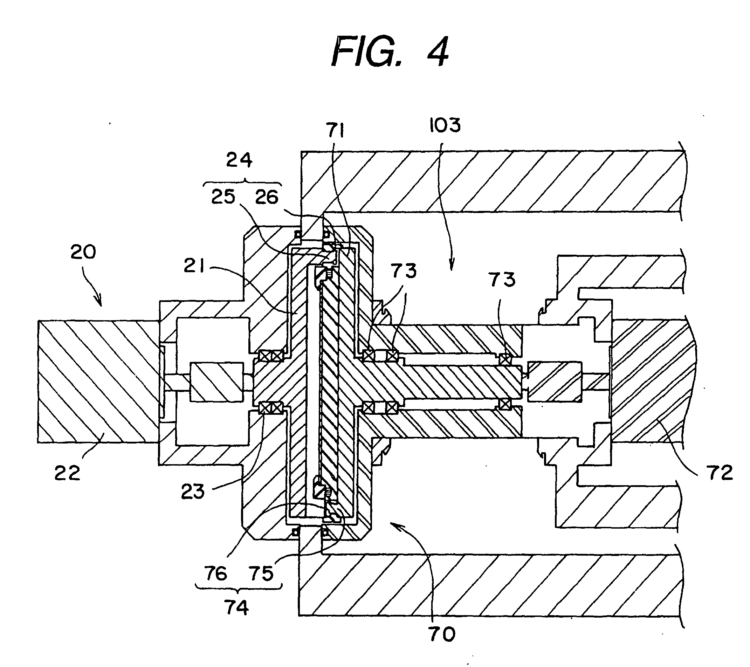

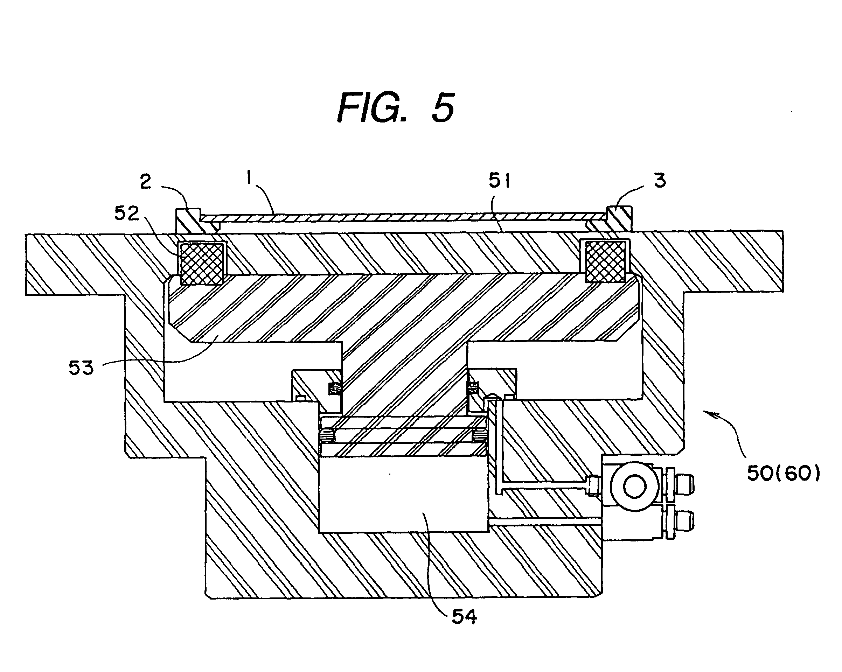

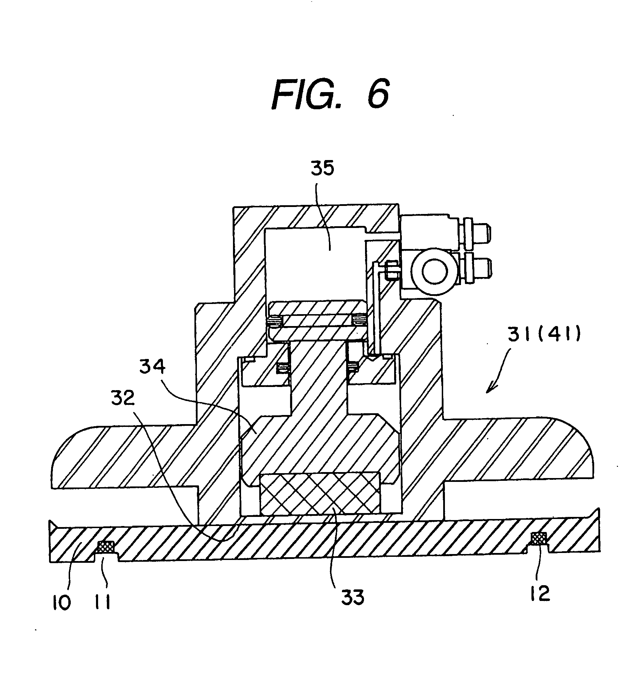

Next, the procedure of transferring the substrate 1, mask 2 and carrier 10 by the substrate replacing hand 20 in the substrate replacing unit 6 is described. See FIG. 2 which is a front view of the carrier 10, FIG. 3 which is a cross-sectional view illustrating the substrate 1, mask 2 and carrier 10 transferred between the substrate replacing hand 20 and first or second arm head 30 or 40, FIG. 4 which is a cross-sectional view illustrating the substrate 1, mask 2 and carrier 10 transferred between the carrier holder 70 and substrate replacing hand 20, FIG. 5 which is a cross-sectional view illustrating the substrate 1 and mask 2 held by the first or second stage 50 or 60, and FIG. 6 which is a cross-sectional view illustrating the carrier 10 held by the first or second arm head 30 or 40 for reference. The substrate 1 in this embodiment has no through-hole at the center and needs no inner mask, accordingly.

In this embodiment, the carrier 10 is provided with a circularly arranged groove 11 on the substrate supporting surface to hold the projection 3 on the back side of the outer mask 2, and also with small magnets 12 arranged on the basal plane of the groove 11. Moreover, the carrier fixing through-holes 13 and carrier attaching/detaching through-holes 14 are arranged around the outer periphery of the circularly arranged groove 11 at the same distance from the carrier center.

Each of these carrier fixing through-holes 13 and carrier attaching/detaching through-holes 14 is composed of the circumferentially extending elongate through-hole 15 of smaller diameter and circular through-hole 16 of larger diameter, connected to each other at the ends to form the continuous hole. The carrier fixing through-holes 13 are positioned 90° apart from each other, and each of the carrier attaching/detaching through-holes 14 is positioned at the midpoint between the carrier fixing through-holes 13. These holes 13 and 14 are positioned in such a way that the position of the elongate hole relative to the circular hole 16 alternates along the circumference.

First, the substrate charging/discharging chamber 103 is purged with dried nitrogen gas or the like while it is containing the substrate 1, before being open to the air. The substrate 1, mask 2 and carrier 10 are supported by the carrier holder 70 in the sputtering device 100, as illustrated in FIG. 4. The carrier fixing member 71 in the carrier holder 70 is connected to the motor 72, by which it is driven to rotate while being supported by the bearings 73. The mask 2 is fast held and fixed on the carrier 10 magnetically by the small magnets 12 provided in the carrier 10. The almost circular substrate 1 is held by the carrier 10 while being placed between the mask 2 and carrier 10.

The carrier holder 70 has a magnet (not shown) and carrier fixing pins 74 provided in the carrier fixing member 71 and arranged to correspond to the respective carrier fixing holes 13. Each of the carrier fixing pins 74 is composed of a smaller-diameter section 75 and larger-diameter section 76 provided at the end of the smaller-diameter section, the former having a diameter to allow the smaller-diameter hole 15 of the carrier fixing hole 13 to be fit and longer than depth of the smaller-diameter hole 15 of the carrier fixing hole 13 while the latter having a diameter to allow the larger-diameter hole 16 of the fixing hole 13 to be fit but not to allow the smaller-diameter hole 15 to be fit. Also, the length of the smaller-diameter section 75 of the carrier fixing pin 74 is set so as to be larger than the depth of the smaller-diameter hole 15 of the carrier fixing hole 13.

The mask 2 and carrier 10 are magnetically held by the carrier holder 70 by a magnet (not shown). The fixing pin 74 is fit into the larger-diameter hole 16 of the carrier fixing hole 13, and is then rotated together with the carrier fixing member 71 by the carrier holder rotating motor 72 towards the smaller-diameter hole 15 of the carrier fixing hole 13. This fits the larger-diameter section 76 of the carrier fixing pin 74 into the smaller-diameter hole 15 of the carrier fixing hole 13 to fix the carrier 10 on the carrier holder 70.

The substrate replacing hand 20 has the carrier supporting member 21, connected to the carrier attaching/detaching motor 22, by which it is driven to rotate while being supported by the bearings 23. The carrier supporting member 21 fixes and holds the carrier 10 on the carrier supporting plane, which is provided with the carrier attaching/detaching pins 24, each being arranged at a position to correspond to the carrier attaching/detaching hole 14 provided in the carrier 10 and having the same shape as the carrier fixing pin 74, described earlier.

Like the carrier fixing pin 74, the carrier attaching/detaching pin 24 is composed of the smaller-diameter section 25 and larger-diameter section 26 provided at the end of the section 25, the former being longer than depth of the smaller-diameter hole 15 of the carrier attaching/detaching hole 14. These carrier attaching/detaching pins 24 constitute the carrier attaching/detaching means which works in concert with the corresponding carrier attaching/detaching holes 14. The substrate replacing hand 20 moves closer to the carrier holder 70 holding the substrate 1 and the like to fit each of the carrier attaching/detaching pins 24 into the corresponding larger-diameter hole 16 of the carrier attaching/detaching hole 14. Then, the carrier attaching/detaching rotating motor 22 rotates the carrier attaching/detaching pin 24 fit into the larger-diameter hole 16 towards the smaller-diameter hole 15 to fix the carrier 10 on the substrate replacing hand 20.

Almost simultaneously, the carrier holder rotating motor 72 rotates the carrier fixing pin 74 together with the carrier fixing section 71 towards the larger-diameter hole 16 of the carrier fixing hole 13. This allows the substrate 1, mask 2 and carrier 10 to be detached from the carrier holder 70, completing transfer of the substrate 1 and the like from the carrier holder 70 to the substrate replacing hand 20. Then, the substrate replacing hand 20 is driven back by a substrate replacing hand driving mechanism (not shown) to change the vertical attitude which almost vertically supports the substrate 1 facing the carrier holder 70 to the horizontal attitude which almost horizontally supports the substrate 1 from the above.

The first and second arm heads 30 and 40 are standing by at the respective stand-by position 80 while the substrate replacing hand 20 is changing its attitude to the horizontal one after receiving the substrate 1, the mask 2 and carrier 10 from the carrier holder 70. At the same time, the carrier 10 to be transferred to the carrier holder 70 is being held by the first head 31 of the first arm head 30 (the condition shown in FIG. 6) and cooled by nitrogen gas or the like at the corresponding stand-by position 80, while the second head 41 of the second arm head 40 is standing by at the corresponding stand-by position 80 without holding the carrier 10 or the like to wait ready for receiving the film-coated substrate 1 and the like.

The uncoated substrate 1 is waiting on the first stage 50 (the condition shown in FIG. 5) to be received by the carrier 10 held by the first head 31. The uncoated substrate 1 on which the mask 2 is mounted is placed on the first stage 50 with the surface to be film-coated facing downwards (facing the stage surface). The stage 50 has the stage magnets 52 inside, supported by the stage magnet arm 53 connected to the stage air cylinder 54. These stage magnets 52, magnet arm 53 and air cylinder 54 constitute the mask fixing means.

The stage magnets 52 are driven by the stage air cylinder 54 to move between the nearest and farthest positions from the mask supporting plane 51 (stage surface), while being supported by the stage magnet arm 53. The outer mask 2 of a magnetic material is fixed and held on the stage surface, when the stage magnet 52 moves to the nearest position to the surface 51 (the condition shown in FIG. 5), which is accompanied by the substrate 1 being held at the given position corresponding to the mask 2 position.

As shown in FIG. 6, each of the first and second heads 31 and 41 has the head magnet 33 inside, which is supported by the head magnet arm 34 connected to the head air cylinder 35. The head magnet 33 is driven by the cylinder 35 to move between the nearest and farthest positions from the carrier supporting plane 32 in the head 31, while being supported by the head magnet arm 34. The carrier 10 with the small magnets 12 inside is magnetically fixed and held on the carrier supporting plane 32 by the small magnets 12, when the head magnet 33 moves to the nearest position to the carrier supporting plane 32 (the condition shown in FIG. 6). This condition represents the first head 31 standing by at present.

Next, the first and second arm heads 30 and 40 rotate around the connection by the arm head driving mechanism (not shown), and stop when the first head 31 reaches over the first stage 50 and the second head 41 over the substrate replacing hand 20 in the horizontal position. Then, the head 31 is moved downwards to the first stage 50, and the head 41 to the carrier supporting member 21 of the substrate replacing hand 20 in the horizontal position. These heads stop, when the carrier 10 held by the first head 31 comes into contact with the mask 2 and substrate 1 on the first stage 50, and, at the same time, the second head 41 comes into contact with the carrier 10 held by the substrate replacing hand 20. The contact conditions are confirmed by a common touch sensor (not shown).

In the above conditions, the stage air cylinder 54 drives the stage magnets 52 to the farthest position from the first stage 50 surface. Therefore, the magnetic force by the magnets 52 on the mask 2 becomes smaller than the combined magnetic force on the mask 2 by the small magnets 12 in the carrier and head magnet 33 in the first head 31, with the result that the substrate 1 and mask 2 fast adhere to the carrier 10. They are as a unit held by the first head 31.

As described above, the second head 41 descends without holding the carrier 10 and the like, together with the first head 31, and stops when its carrier supporting member 21 comes into contact with the back side of the carrier 10 supported by the substrate replacing hand 20. Next, the head air cylinder 35 drives the head magnet 33 to the nearest position from the carrier supporting plane 32, which magnetically attracts the substrate 1, and mask 2 and carrier 10 holding the substrate 1 in-between. Then, the carrier attaching/detaching rotating motor 22 rotates the carrier supporting member 21 and carrier attaching/detaching pins 24 in the substrate replacing hand 20, to release the carrier attaching/detaching pins 24 from the corresponding carrier attaching/detaching holes 14.

On completion of the above procedure, the first head 31 holds the uncoated substrate 1, and mask 2 and carrier 10 holding the substrate 1 in-between, and the second head 41 holds the film-coated substrate 1, and mask 2 and carrier 10 holding the film-coated substrate 1 in-between. In these conditions, the arm head driving mechanism (not shown) moves the first and second arm heads 30 and 40 upwards to a given height, and rotate them until the first head 31 reaches over the substrate replacing hand 20 and the second head 41 over the second stage 60.

Then, the first and second arm heads 30 and 40 descend until the carrier attaching/detaching pins 24 in the substrate replacing hand 20 are fit into the corresponding carrier attaching/detaching holes 14 in the carrier 10 held by the first head 31. At the same time, the mask 2 held by the second head 41 comes into contact with the mask supporting plane 51 in the second stage 60. At this point, the carrier supporting member 21 in the substrate replacing hand 20 and carrier attaching/detaching pins 24 are rotated by the carrier attaching/detaching rotating motor 22 to move. This moves the carrier attaching/detaching pins 24 to the corresponding smaller-diameter holes 15 of the carrier attaching/detaching holes 14, to fit the larger-diameter sections 26 of the carrier attaching/detaching pins 24 into the corresponding smaller-diameter holes 15 of the carrier attaching/detaching holes 14, fixing the uncoated substrate 1, and mask 2 and carrier 10 holding the substrate 1 in-between on the substrate replacing hand 20.

Then, the head air cylinder 35 drives the head magnet 33 in the first head 31 to the farthest position from the carrier supporting plane 32 in the first head 31. This transfers the substrate 1 and the like from the first head 31 to the substrate replacing hand 20, and, at the same time, the mask 2 and substrate 1 from the second head 41 to the second stage 60. The second stage 60 has the same structure as the first stage 50 described earlier.

While the mask 2 is kept in contact with the second stage 60, the stage air cylinder 54 drives the stage magnet 52 held by the stage magnet arm 53 in the second stage 60 to the nearest position from the mask supporting plane 51 as the stage surface. In this condition, the combined magnetic force on the mask 2 by the head magnet 33 in the second head 41 and the small magnets 12 in the carrier 10 being held by the head 41 becomes smaller than the magnetic force on the mask 2 by the stage magnets 52.

However, the head magnet 33 is designed to have a stronger magnetic force than the stage magnets 52 on the small magnets 12 in the carrier 10. Therefore, the substrate 1 and mask 2 are magnetically held by the stage 60, and the carrier 10 by the head 41 as the second head 41 ascends. The first head 31, which has transferred the substrate 1, mask 2 and carrier 10 to the substrate replacing hand 20, also ascends simultaneously.

Then, the arm head driving mechanism rotates the first and second arm heads 30 and 40 to move to the respective stand-by position 80. In this condition, the substrate 1, mask 2 and carrier 10 are transferred from the substrate replacing hand 20 to the carrier holder 70, i.e., the order of the above procedure is reversed. The film-coated substrate 1 and mask 2 set on the second stage 60 are replaced by the uncoated substrate 1 and mask 2 by a substrate transferring robot (not shown). At the same time, the charging/discharging chamber, which contains the carrier holder 70 holding the uncoated substrate 1 and the like, is exhausted, to start the film forming process for the substrate 1.

Then, the film-coated substrate 1, mask 2 and the carrier 10 holding them are transferred, while being supported by the carrier holder 70, to the substrate charging/discharging chamber 103, which is then open to the air. The conditions in which the second stage 60 supports the uncoated substrate 1 and mask 2, the second head 41 holds the carrier 10, the first stage 50 and first head 31 support nothing are the same as those described above for transferring the substrate 1, mask 2 and carrier 10, except that each stage and head are replaced. Transfer of the substrate is repeated in the same manner as in the above procedure, except that each stage and head are replaced.

The above-described substrate transfer procedure allows the carrier held by the head to be cooled in a natural or forced manner while it is at the stand-by position. This allows a thin film to be formed by sputtering on a substrate set on a carrier which is kept controlled at a constant temperature or a given temperature or lower. It is therefore possible to control substrate temperature rise by use of a carrier of adequate heat capacity, even when a film forming process which exposes a substrate to a plasma for a certain time or longer is needed.

This embodiment forms a film on a substrate having no through-hole at the center. However, the present invention is not limited to such a substrate, and also applicable to a substrate with a through-hole at the center. Moreover, this embodiment depends on a magnetic force for fixing a mask on a stage. However, various other fixing means, e.g., fixing under a vacuum, may be also used. Still more, this embodiment uses attaching/detaching pins for carrier attaching/detaching. However, various other fixing means, e.g., fixing under a vacuum, may be also used for the above purpose. A mask for covering the substrate center, the so-called inner mask may be additionally used. The inner mask may be magnetically fixed on the substrate by one or more magnets provided within the carrier. The magnet may be separately provided for the above purpose.

Still more, this embodiment transfers a substrate and the like by a substrate replacing hand, arm head and stage while they are kept horizontal. However, they may be transferred while being kept almost vertical. Still more, this embodiment cools a carrier with dried nitrogen or the like at a stand-by position. However, the cooling method is not limited to this. For example, a plate-shape cooling mechanism or the like cooled with water or the like may be placed underneath a head at a stand-by position, where it is pressed to the carrier in the air, or carrier temperature may be controlled by a water-cooling mechanism or the like provided in the head itself.

Still more, this embodiment employs a sputtering device for forming thin films. However, the film may be formed by various other devices, e.g., evaporator, CVD device or the like. The present invention is applicable not only to optical disks but also to other products whose central part is removed later, e.g., all types of disk-like members including hard disks.

The present invention allows a substrate and the like to be held by a carrier whose temperature is kept at a constant level or a given level or lower. Therefore, it can widen conditions for forming a thin film on a substrate, because heat energy given to a substrate can be released to a cooled carrier, even when a film forming process which exposes a substrate to a plasma for a long time is adopted.

## Claims

1. A substrate replacing unit transferring, between carrier holders in a film forming device, a substrate, mask of a magnetic material for covering a given part on the substrate and carrier comprising a magnetic material which holds the substrate and mask and is held by the carrier holder, **characterized in that** the unit comprises
a substrate replacing hand equipped with a carrier attaching/detaching means for receiving the carrier on which the substrate and mask are mounted from the carrier holder and for holding the substrate, mask and carrier,
a head facing the substrate replacing hand for transferring the substrate, mask and carrier by a magnetic force between itself and the hand
a mask fixing means for fixing the mask thereon,
a stage facing the head at a position different from that of the substrate replacing hand for transferring the mask and substrate between itself and head by the mask fixing means, and
a stand-by position located between the substrate replacing hand and stage, at which the carrier held by the head is cooled after it transfers the substrate and mask to the stage.

2. A unit according to Claim 1, **characterized in that** the carrier attaching/detaching means in the substrate replacing hand works in concert with carrier attaching/detaching holes provided in the carrier to pass therethrough, each being composed of an elongate through-hole of a given width and smaller diameter and an adjacent circular through-hole of a diameter longer than the width of the elongate through-hole, and the substrate replacing hand is composed of a substrate fixing member and carrier fixing pins, the substrate fixing member working to fix the substrate, mask and carrier, and being rotatable in the direction perpendicular to the substrate, and each of the carrier fixing pins being provided at a position corresponding to that of one of the carrier attaching/detaching holes in the substrate fixing member, and composed of a smaller-diameter section and larger-diameter section provided at the end of the smaller-diameter section, the former having a diameter to allow the smaller-diameter hole of the carrier fixing hole to be fit and longer than depth of the smaller-diameter hole of the carrier fixing hole while the latter having a diameter to allow the larger-diameter hole of the fixing hole to be fit but not to allow the smaller-diameter hole to be fit.

3. A substrate replacing unit replacing, between carrier holders in a film forming device, a film-coated and uncoated substrate with each other together with a mask for covering a given part on the substrate and carrier which holds the substrate and mask and is held by the carrier holder, **characterized in that** the unit comprises
a substrate replacing hand which replaces, between the carrier holders, the film-coated and uncoated substrate with each other together with the mask and carrier,
a stage on which the film-coated or uncoated substrate and mask are set, and
an arm head which receives the film-coated substrate, mask and carrier from the substrate replacing hand, transfers the film-coated substrate and mask to the stage, stands by for a given time while holding the carrier, and then receives the uncoated substrate and mask from the stage.

4. A method of replacing, between carrier holders in a film forming device, a substrate, mask of a magnetic material for covering a given part on the substrate and carrier comprising a magnetic material which holds the substrate and mask and is held by the carrier holder, comprising:
a step of receiving the substrate, mask and carrier from the carrier holder by a substrate replacing hand,
a step of receiving the substrate, mask and carrier from the substrate replacing hand by an arm head,
a step of setting the substrate and mask received by the arm head on a stage,
a step of replacing the substrate and mask by a new substrate and mask on the stage,
a step of transferring the new substrate and mask together with the carrier which holds them to the substrate replacing hand by the arm head, and
a step of transferring the new substrate and mask together with the carrier which holds them to the carrier holder by the substrate replacing hand, **characterized in that**
the carrier held by the arm head is cooled while the substrate and mask are replaced on the stage.
